# EUROPEAN PATENT APPLICATION

(11) **EP 4 119 859 A1**
(43) Date of publication of application: **18.01.2023**
(21) Application number: 22185186.8
(22) Date of filing: 15.07.2022
(51) Int. Cl.: F24F 11/39, F24F 11/52, F24F 11/89, F24F 11/88, G05B 15/02, G01R 31/34, F24F 140/50, F24F 140/60

(54) **CURRENT MONITOR AIR FILTER REPLACEMENT**

(30) Priority: 16.07.2021 US 202163222782 P
(71) Applicant: Carrier Corporation, Palm Beach Gardens, FL 33418 (US)
(72) Inventor: BLAKE, Jonathan, East Syracuse, NY 13221 (US); ARNEDO, Luis, Farmington, CT 06032 (US); SMYTH, Michael S., Fort Wayne, IN 46802 (US)
(74) Representative: Dehns

(57) **Abstract**

A method (400) of monitoring an air filter (126) in a heating, ventilation, and air conditioning (HVAC) system (100) that includes operating (404) a blower motor (115) at a desired torque; monitoring (406) a horsepower (260) of the blower motor over a selected time period when the blower motor is operating at the desired torque; determining (408) a moving average of the horsepower of the blower motor over the selected time period; detecting (410) when the moving average drops below an established baseline moving average by a selected percentage; and activating (412) a notification to check or change the air filter of the HVAC system.

## Description

The disclosure herein generally relates to a heating, ventilation, and air conditioning (HVAC) system. More specifically, the present invention relates to a method for monitoring an air filter in an HVAC system and a controller for an HVAC system.

Modern structures, such as office buildings and residences, utilize heating, ventilation, and air conditioning (HVAC) systems having controllers that allow users to control the environmental conditions within these structures. These controllers have evolved over time from simple temperature based controllers to more advanced programmable controllers, which allow users to program a schedule of temperature set points in one or more environmental control zones for a fixed number of time periods as well as to control the humidity in the control zones, or other similar conditions. Typically, these HVAC systems use an air handler that includes a motor and a fan to deliver the conditioned air to an interior space.

Commonly the HVAC system will include an air filter (e.g., upstream of the fan) to remove impurities from the air passing through the HVAC system. Over time, the air filter becomes clogged, and eventually should be replaced. A clogged air filter presents challenges to the further operation of the fan, and increases the load on the fan. Current methods of monitoring whether the air filter needs to be replaced require pressure sensors, which increases the cost and complexity of the HVAC system.

According to a first aspect, a method of monitoring an air filter in a heating, ventilation, and air conditioning (HVAC) system, is provided. The method includes: operating a blower motor at a desired torque; monitoring a horsepower of the blower motor over a selected time period when the blower motor is operating at the desired torque; determining a moving average of the horsepower of the blower motor over the selected time period; detecting when the moving average drops below an established baseline moving average by a selected percentage; and activating a notification to check or change the air filter of the HVAC system.

The method may include establishing the established baseline moving average.

The establishing the established baseline moving average may include: operating the blower motor at the desired torque; monitoring the horsepower of the blower motor over a baseline time period when the blower motor is operating at the desired torque; and determining the established baseline moving average of the horsepower of the blower motor over the baseline time period.

The monitoring the horsepower of the blower motor over the selected time period when the blower motor is operating at the desired torque may include: monitoring an electrical current provided to the blower motor over the selected time period when the blower motor is operating at the desired torque; monitoring an operating speed of the blower motor over the selected time period when the blower motor is operating at the desired torque; and calculating the horsepower based on the electrical current and the operating speed.

The method may include establishing the selected percentage.

The activating the notification to check or change the air filter of the HVAC system may include: displaying the notification to check or change the air filter of the HVAC system on an interface element of a system control unit of the HVAC system.

According to a second aspect, a controller for a heating, ventilation, and conditioning (HVAC) is provided. The controller includes: a processor; and a memory including computer-executable instructions that, when executed by the processor, cause the processor to perform operations. The operations include: operating a blower motor at a desired torque; monitoring a horsepower of the blower motor over a selected time period when the blower motor is operating at the desired torque; determining a moving average of the horsepower of the blower motor over the selected time period; detecting when the moving average drops below an established baseline moving average by a selected percentage; and activating a notification to check or change an air filter of a HVAC system, wherein the controller is an electronically commutated motor (ECM) or an equipment control board.

The operations may include: establishing the established baseline moving average.

The establishing the established baseline moving average may include: operating the blower motor at the desired torque; monitoring the horsepower of the blower motor over a baseline time period when the blower motor is operating at the desired torque; and determining the established baseline moving average of the horsepower of the blower motor over the baseline time period.

The monitoring the horsepower of the blower motor over the selected time period when the blower motor is operating at the desired torque may include: monitoring an electrical current provided to the blower motor over the selected time period when the blower motor is operating at the desired torque; monitoring an operating speed of the blower motor over the selected time period when the blower motor is operating at the desired torque; and calculating the horsepower based on the electrical current and the operating speed.

The operations may include: establishing the selected percentage.

The activating the notification to check or change the air filter of the HVAC system may include: displaying the notification to check or change the air filter of the HVAC system on an interface element of a system control unit of the HVAC system.

According to a third aspect, there is provided a controller for a heating, ventilation, and conditioning (HVAC), the controller comprising: a processor; and a memory including computer-executable instructions that, when executed by the processor, cause the processor to perform a method according to the first aspect and optionally including any of the other method features described above, wherein the controller is an electronically commutated motor (ECM) or an equipment control board.

According to a fourth aspect, a computer program product embodied on a non-transitory computer readable medium is provided. The computer program product includes instructions that, when executed by a processor, cause the processor to perform operations including: operating a blower motor at a desired torque; monitoring a horsepower of the blower motor over a selected time period when the blower motor is operating at the desired torque; determining a moving average of the horsepower of the blower motor over the selected time period; detecting when the moving average drops below an established baseline moving average by a selected percentage; and activating a notification to check or change an air filter of a HVAC system.

The operations may include: establishing the established baseline moving average.

The establishing the established baseline moving average may include: operating the blower motor at the desired torque; monitoring the horsepower of the blower motor over a baseline time period when the blower motor is operating at the desired torque; and determining the established baseline moving average of the horsepower of the blower motor over the baseline time period.

The monitoring the horsepower of the blower motor over the selected time period when the blower motor is operating at the desired torque may include: monitoring an electrical current provided to the blower motor over the selected time period when the blower motor is operating at the desired torque; monitoring an operating speed of the blower motor over the selected time period when the blower motor is operating at the desired torque; and calculating the horsepower based on the electrical current and the operating speed.

The operations may include: establishing the selected percentage.

The activating the notification to check or change the air filter of the HVAC system may includes: displaying the notification to check or change the air filter of the HVAC system on an interface element of a system control unit of the HVAC system.

According to a fifth aspect, there is provided a computer program product embodied on a non-transitory computer readable medium, the computer program product including instructions that, when executed by a processor, cause the processor to perform a method according to the first aspect and optionally including any of the other method features described above.

Technical effects of aspects of the present disclosure include monitoring a horse power of the blower motor for an HVAC system to determine whether an air filter in the HVAC system needs to be replaced.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

The following description should not be considered limiting in any way. With reference to the accompanying drawings, like elements are numbered alike:
FIG. 1 is a schematic illustration of a heating, ventilation, and air conditioning HVAC system;
FIG. 2 illustrates a chart depicting external static pressure in the duct system versus a flow rate through the duct system;
FIG. 3 illustrates a chart depicting external static pressure in the duct system versus the flow rate through the duct system and horsepower of the blower motor versus the flow rate through the duct system; and
FIG. 4 is a flow diagram illustrating a method of monitoring an air filter in an HVAC system of FIG. 1.

A detailed description of one or more examples of the disclosed apparatus and method are presented herein by way of exemplification and not limitation with reference to the Figures.

In certain applications, furnace and fan coil low tier units have static torque settings. If there is a change in the operational environment, such as a duct work blockage or air filter clogging over-time, the amount of airflow generated by the HVAC system may degrade from factory performance.

An ECM for a heating, ventilation, and air conditioning (HVAC) system utilizes a pulse width modulation (PWM) signal to communicate with the furnace or fan coil system control board or ECM controller. The ECM may be provided with a three phase electrical current to control operation. Examples disclosed herein utilize electrical current measurements provided to the blower motor and a speed of the blower motor to determine when an air filter has been clogged to the point that it should be replaced.

Examples disclosed herein monitor the three phase currents provided to the ECM and the motor speed of the ECM at each given factory setpoint, then the average electrical power for each setpoint is tracked. As the static pressure increases over-time, the electrical power decreases, and a trip threshold is reached, then a notification would be sent to the user to check air filter.

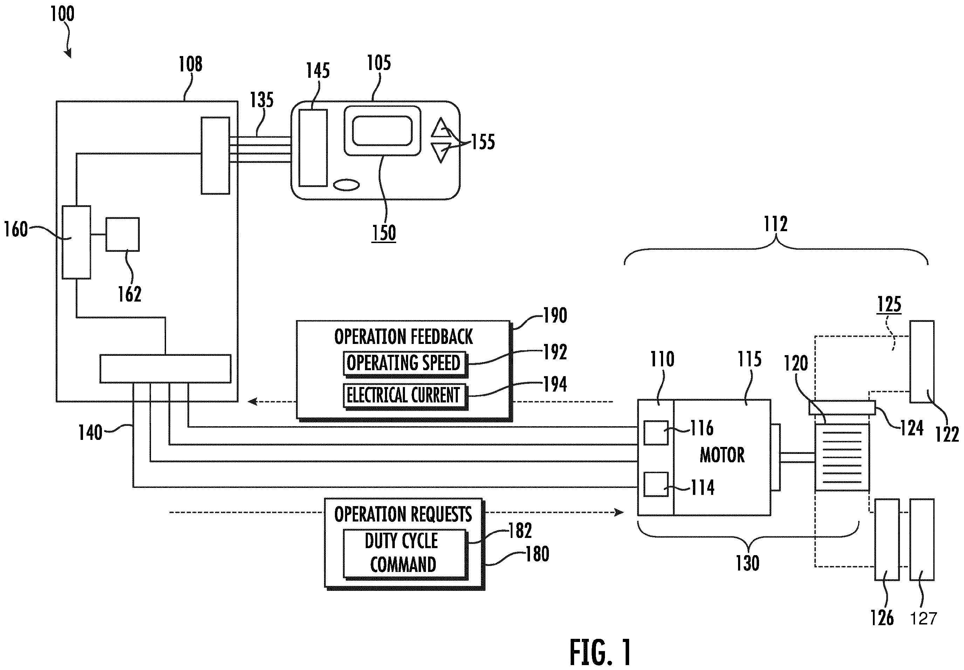

Referring now to the drawings, FIG. 1 illustrates a schematic view of an HVAC system 100 according to an example of the present disclosure. Particularly, the HVAC system 100 includes a system controller or system control unit 105, an equipment control board 108, an ECM controller 110, and a blower system 130 (as part of an air handler 112) having a blower motor 115 and a centrifugal blower unit 120 connected to the duct system 125.

As shown, HVAC system 100 operates to heat or cool an environment 122. An air handler unit 124, such as a furnace or fan coil, is provided with air from an inlet air duct 127. Typically, an air filter 126 is placed on the inlet air duct 127, and upstream of the blower unit 120. The air filter 126 is configured to filter airflow through the duct system 125. The blower unit 120 pulls air through the inlet air duct 127, air filter 126, and through the air handler unit 124.

In an example, the blower motor 115 may be a dual motor ECM or single motor ECM. The system control unit 105 is in operative communication with the equipment control board 108 over system communication bus 135, which communicates signals between the system control unit 105 and the equipment control board 108. As a result of the bi-directional flow of information between the system control unit 105 and the equipment control board 108, the algorithms described in illustrated examples may be implemented in either control unit 105 or the equipment control board 108. Also, in some examples, certain aspects of the algorithms may be implemented in control unit 105 while other aspects may be implemented in the equipment control board 108.

In one example, the system control unit 105 includes a computing system 145 having a program stored on nonvolatile memory to execute instructions via a microprocessor related to aspects of an airflow rate algorithm to determine the predicted operating parameters of air volume flow, air mass flow, external static pressure load, and operating power consumption of the blower unit 120 in HVAC system 100. In examples, the microprocessor may be any type of processor (CPU), including a general purpose processor, a digital signal processor, a microcontroller, an application specific integrated circuit, a field programmable gate array, or the like.

The system control unit 105 of the illustrated example includes a user interface element 150 such as, for example, a graphic user interface (GUI), a CRT display, a LCD display, or other similar type of interface by which a user of the HVAC system 100 may be provided with system status and/or the determined operating parameters of the air handler 112. Also, the system control unit 105 includes a user input element 155 by which a user may change the desired operating characteristics of the HVAC system 100, such as airflow requirements. The user may also enter certain specific aspects of the air handler 112 installation such as, for example, the local altitude for operation of the air handler 112, which may be used in the various algorithms. It is to be appreciated that the system control unit 105 implements aspects of an airflow control algorithm for determining in an example, the operating parameters including air volume flow rate or air mass flow rate, the blower unit 120 power consumption, and duct static pressure at the extremes of the operating range of the blower motor 115 (e.g., at or near maximum motor RPM). The determination of these operating parameters through the algorithms eliminates a need to measure these parameters against published parameters, thereby providing for self-certification of the air handler 112 and diagnostics of the HVAC system 100. The determined operating parameters may be compared to published, expected parameters to provide a certification that the air handler 112 meets the published parameters. It should be appreciated that while aspects of the algorithms described above may be executed in the ECM controller 110, in other examples, any of the above algorithms may also be executed in the system control unit 105 or the equipment control board 108.

Also shown, HVAC system 100 includes the equipment control board 108 operably connected to the blower system 130 for transmitting operation requests 180 to the blower system 130. The equipment control board 108 may be operably connected to the ECM controller 110. The equipment control board 108 includes a processor 160 and a memory 162, which stores operational characteristics of blower system 130 that are specific to the model of the air handler unit 124 being used. In some non-limiting examples, the operational characteristics include blower diameter, blower operating torque, a cabinet size of the air handler unit 124, and a motor power rating of the blower motor 115.

In one example, the equipment control board 108 transmits operation requests 180 to the ECM controller 110 via a motor communication bus 140. The ECM controller 110 is configured to receive the operation requests 180 and control the blower motor 115 in accordance with the operation requests 180. The ECM controller 110 may also include an associated memory 116 and processor 114. The ECM controller 110 may be an electronic controller including a processor and an associated memory comprising computer-executable instructions (i.e., computer program product) that, when executed by the processor, cause the processor to perform various operations. The processor may be, but is not limited to, a single-processor or multi-processor system of any of a wide array of possible architectures, including field programmable gate array (FPGA), central processing unit (CPU), application specific integrated circuits (ASIC), digital signal processor (DSP) or graphics processing unit (GPU) hardware arranged homogenously or heterogeneously. The memory may be but is not limited to a random access memory (RAM), read only memory (ROM), or other electronic, optical, magnetic or any other computer readable medium.

The operation requests 180 include a torque command 182. In one example, the equipment control board 108 receives operation feedback 190 from the ECM controller 110 of the blower motor 115 via the motor communication bus 140. The operation feedback 190 includes an operating speed 192 of the blower motor 115 and an electrical current 194 of the blower motor 115. In order to determine the operating speed 192 of the blower motor 115, the motor control algorithm provides sinusoidal phases currents to the blower motor 115 and the operating speed 192 of the blower motor 115 is directly related to the frequency of the phase currents. The assumption is that the motor is operating in its normal condition where rotor is synched with the rotating magnetic field of the stator.

The ECM controller 110 receives the torque commands 182 from the equipment control board 108 and impels blades of the blower unit 120 at the commanded motor operating torque. In an example, the processor 160 of the equipment control board 108 implements one or more algorithms for determining the air volume flow rate, air mass flow rate, the static pressure in the duct system 125 over the full range of duct restrictions and airflow range, and operating power consumption by the blower system 130 based on the specific characteristic constants of the air handler unit 124 including characteristics of the specific blower motor 115 and blower unit 120 being used.

In an example, the processor 160 of the equipment control board 108 is configured to monitor an electrical current 194 being drawn by the blower motor 115 and the operating speed 192 of the blower motor 115, which serve as an indicator that the air filter 126 needs to be changed. The electrical current 194 and the operating speed 192 of the blower motor 115 serve as variables in calculating a horsepower of the blower motor 115. Conventionally, horsepower is a function of operating speed 192 and torque of the blower motor 115. Examples disclosed herein may utilize a relative measurement of horsepower based on operating speed 192 and variations in electrical current 194, instead of the classical calculation of horsepower that used operating speed 192 and torque. Variations in the electrical current 194 indicate variations in horsepower.

As discussed further herein, if the horsepower of the blower motor 115 for the same airflow setpoint is reduced over a time period, it may mean that the static pressure in the duct system 125 has increased over that same time period. This is because the blower motor 115 will be operating at the same voltage to achieve the commanded airflow set point but will be operating at a lower operating speed 192 and pulling less electrical current 194 as the blower unit 120 encounters higher external static pressure in the duct system 125. The external static pressure in the duct system 125 is the air pressure within the duct system 125. An air filter 126 that is dirty or clogged will increase the external static pressure in the duct system 125 by restricting airflow through the duct system 125. The interface element 150 of the system control unit 105 may display a "Check Air filter" or "Change Air filter" notification if the horse power being drawn by the blower motor 115 falls below a moving average of horsepower by a selected percentage.

In an example, for an operating mode of the HVAC system 100, the system control unit 105 communicates to the equipment control board 108 a command for a desired indoor airflow. The desired indoor airflow depends on user settings such as, for example, the current operating mode, such as heating, cooling, dehumidification, humidification, circulation fan, outside fresh air intake, etc., the number of stages of heating or cooling, and other factors. In some other operating modes, such as gas heating or electric heating, the system control unit 105 commands the stages of heat and the equipment control board 108 determines the corresponding desired indoor airflow. The equipment control board 108 will then command the ECM controller 110 to drive the blower motor 115 accordingly.

Also, the equipment control board 108 is in direct communication with the blower system 130 over motor communication bus 140, which serves to transmit, in one example, torque commands 182 from the equipment control board 108 to the blower system 130. It will be appreciated that the blower system 130 may send operation feedback 190 to the equipment control board 108 such as, in one non-limiting example, the operating speed 192 and the electrical current 194 of the blower motor 115. In an example, the equipment control board 108 is configured to determine the torque command 182 values for the blower motor 115. Further, in an example, the equipment control board 108 is configured to determine the external static pressure in the duct system 125 that is external to the air handler unit 124.

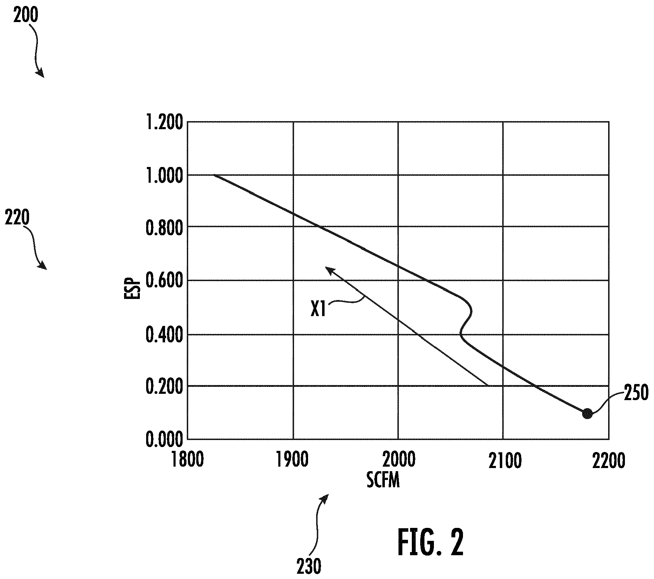

Referring now to FIG. 2, with continued reference to FIG. 1, a chart 200 depicting external static pressure 220 in the duct system 125 versus a flow rate 230 through the duct system 125 is illustrated, in accordance with an example of the present disclosure. The flow rate 230 is measured in cubic feet per minute (CFM) (1 CFM ≈ 0.00047 cubic meters per second). The external static pressure 220 may be measured in "inches of water column", or just "inches" (1 inch of water column ≈ 250 pascals). As illustrated in FIG. 2, as the external static pressure 220 in the duct system 125 increases then the flow rate 230 through the duct system 125 will decrease. An air filter 126 that is clean may be located at point 250 on the chart 200. An air filter 126 that is dirty or clogged will increase the external static pressure 220 in the duct system 125 by restricting airflow through the duct system 125, and thus the flow rate 230 through the duct system 125 decreases by moving in the X1 direction on chart 200.

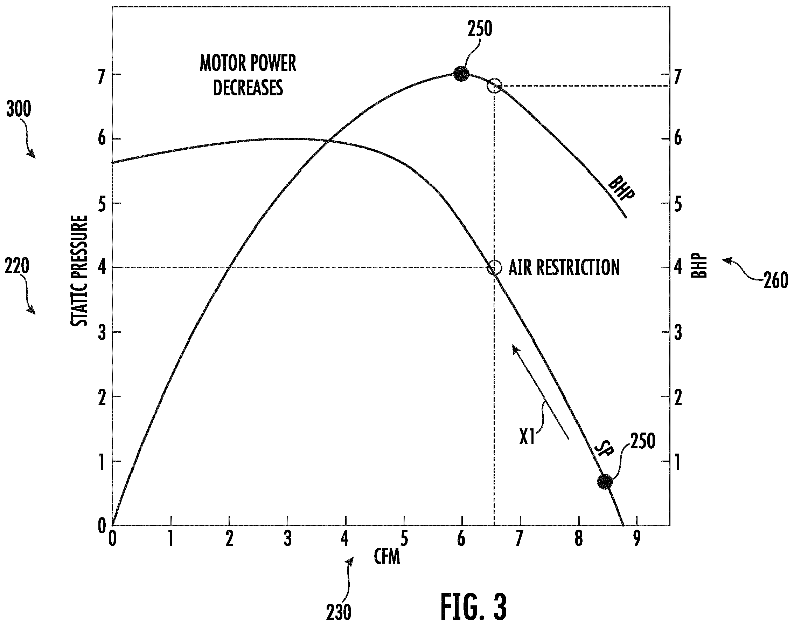

Referring now to FIG. 3, with continued reference to FIGS. 1-2, a chart 300 depicting external static pressure 220 in the duct system 125 versus the flow rate 230 through the duct system 125 and horsepower 260 of the blower motor 115 versus the flow rate 230 through the duct system 125 is illustrated, in accordance with an example of the present disclosure. The flow rate 230 is measured in CFM. The external static pressure 220 may be measured in "inches of water column", or just "inches". The horsepower 260 may be understood as a "base" unit (~746 joule/second). As illustrated in FIG. 3, as the external static pressure 220 in the duct system 125 increases then the flow rate 230 through the duct system 125 will decrease. Further, as the flow rate 230 through the duct system 125 decreases past a critical flow rate 255 then the horsepower 260 will begin to decrease as well. An air filter 126 that is clean may be located at point 250 on the chart 200. An air filter 126 that is dirty or clogged will increase the external static pressure 220 in the duct system 125 by restricting airflow through the duct system 125, and thus the flow rate 230 through the duct system 125 decreases by moving in the X1 direction on chart 200. The horsepower 260 of the blower motor 115 is directly correlated to the electrical current 194 and operating speed 192 of the blower motor 115. Thus, as horsepower 260 of the blower motor 115 decreases the electrical current 194 and operating speed 192 of the blower motor 115 also decreases. As illustrated on chart 300 as the external static pressure 220 increases from an air filter 126 that is dirty or clogged then the horsepower 260, the operating speed 192, and the electrical current 194 of the blower motor 115 will decrease.

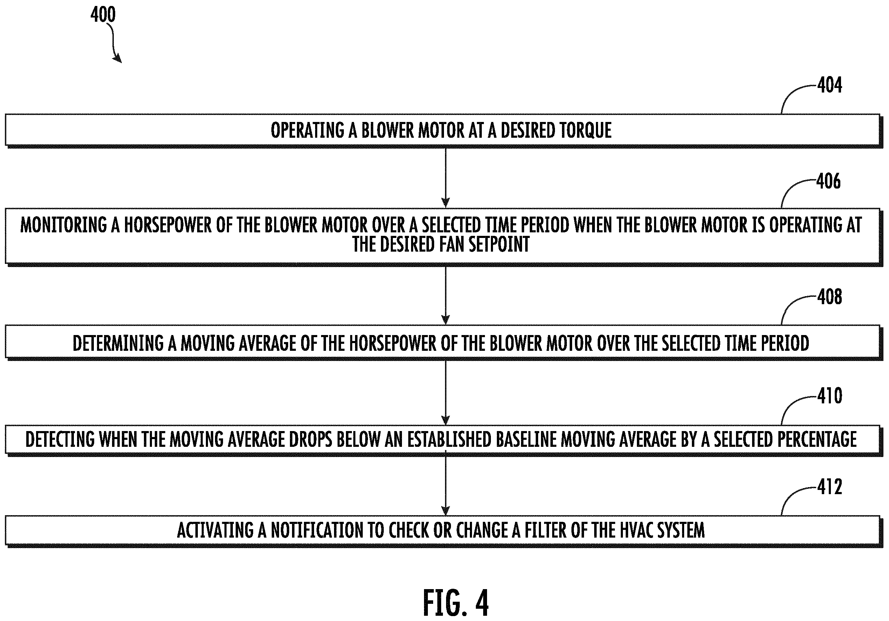

Referring now to FIG. 4, with continued reference to FIGS. 1-3. FIG. 4 shows a flow process illustrating a method 400 of monitoring an air filter 126 in an HVAC system 100. In an example, the method 400 may be performed by the equipment control board 108.

At block 404, a blower motor 115 is operated at a desired torque. The blower motor 115 may be operated at the desired torque by a torque command 182 from the equipment control board 108. There may be different desired torques to achieve different desired fan set points of the HVAC system 100. At block 406, a horsepower 260 of the blower motor 115 is monitored over a selected time period when the blower motor 115 is operating at the desired torque. The horsepower 260 of the blower motor 115 may be monitored in block 406 by monitoring an electrical current 194 provided to the blower motor 115 over the selected time period when the blower motor 115 is operating at the desired torque, monitoring an operating speed 192 of the blower motor 115 over the selected time period when the blower motor 115 is operating at the desired torque, and calculating the horsepower 260 based on the electrical current 194 and the operating speed 192.

At block 408, a moving average of the horsepower 260 of the blower motor 115 over the selected time period is determined. For example, the selected period of time may be one-week.

At block 410, it is detected when the moving average drops below an established baseline moving average by a selected percentage. The method 400 may further comprise that the select percentage is established. The selected percentage may be a factory programmed parameter. It will be based on the specific equipment and normal range of operation. For example, a larger capacity system may have a different tolerance than a smaller capacity system.

At block 412, a notification is activated to check or change an air filter 126 of the HVAC system 100. A notification may be activated by displaying the notification to check or change the air filter 126 of the HVAC system 100 on an interface element 150 of a system control unit 105 of the HVAC system 100.

The method 400 may further comprise establishing the established baseline moving average. The established baseline moving average may be established prior to block 404 by operating the blower motor 115 at the desired torque, monitoring the horsepower 260 of the blower motor 115 over a baseline time period when the blower motor 115 is operating at the desired torque and determining the established baseline moving average of the horsepower 260 of the blower motor 115 over the baseline time period.

While the above description has described the flow process of FIG. 4 in a particular order, it should be appreciated that unless otherwise specifically required in the attached claims that the ordering of the steps may be varied.

As described above, examples can be in the form of processor-implemented processes and devices for practicing those processes, such as a processor. Examples can also be in the form of computer program code (e.g., computer program product) containing instructions embodied in tangible media, such as floppy diskettes, CD ROMs, hard drives, or any other non-transitory computer readable medium, wherein, when the computer program code is loaded into and executed by a computer, the computer becomes a device for practicing the examples. Examples can also be in the form of computer program code, for example, whether stored in a storage medium, loaded into and/or executed by a computer, or transmitted over some transmission medium, loaded into and/or executed by a computer, or transmitted over some transmission medium, such as over electrical wiring or cabling, through fiber optics, or via electromagnetic radiation, wherein, when the computer program code is loaded into and executed by a computer, the computer becomes a device for practicing the examples. When implemented on a general-purpose microprocessor, the computer program code segments configure the microprocessor to create specific logic circuits.

The term "about" is intended to include the degree of error associated with measurement of the particular quantity based upon the equipment available at the time of filing the application. For example, "about" can include a range of ± 8% or 5%, or 2% of a given value.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the claims. In addition, many modifications may be made to adapt a particular situation or material to the teachings of the present disclosure without departing from the scope of the claims. Therefore, it is intended that the present disclosure not be limited to the particular embodiment disclosed as the best mode contemplated for carrying out this present disclosure, but that the present disclosure will include all embodiments falling within the scope of the claims.

## Claims

1. A method (400) of monitoring an air filter (126) in a heating, ventilation, and air conditioning (HVAC) system (100), comprising:
operating (404) a blower motor (115) at a desired torque;
monitoring (406) a horsepower (260) of the blower motor over a selected time period when the blower motor is operating at the desired torque;
determining (408) a moving average of the horsepower of the blower motor over the selected time period;
detecting (410) when the moving average drops below an established baseline moving average by a selected percentage; and
activating (412) a notification to check or change the air filter of the HVAC system.

2. The method (400) of claim 1, comprising:
establishing the established baseline moving average and/or establishing the selected percentage.

3. The method (400) of claim 2, wherein the establishing the established baseline moving average comprises:
operating the blower motor (115) at the desired torque;
monitoring the horsepower (260) of the blower motor over a baseline time period when the blower motor is operating at the desired torque; and
determining the established baseline moving average of the horsepower of the blower motor over the baseline time period.

4. The method (400) of any of claims 1 to 3, wherein the monitoring the horsepower (260) of the blower motor (115) over the selected time period when the blower motor is operating at the desired torque comprises:
monitoring an electrical current provided to the blower motor over the selected time period when the blower motor is operating at the desired torque;
monitoring an operating speed of the blower motor over the selected time period when the blower motor is operating at the desired torque; and
calculating the horsepower based on the electrical current and the operating speed.

5. The method (400) of any of claims 1 to 4, wherein the activating the notification to check or change the air filter (126) of the HVAC system (100) comprises:
displaying the notification to check or change the air filter of the HVAC system on an interface element (150) of a system control unit (105) of the HVAC system.

6. A controller (105, 108, 110) for a heating, ventilation, and air conditioning (HVAC) system, the controller comprising:
a processor (160, 114); and
a memory (162, 116) comprising computer-executable instructions that, when executed by the processor, cause the processor to perform operations (400), the operations comprising:
operating (400) a blower motor (115) at a desired torque;
monitoring (406) a horsepower (260) of the blower motor over a selected time period when the blower motor is operating at the desired torque;
determining (408) a moving average of the horsepower of the blower motor over the selected time period;
detecting (410) when the moving average drops below an established baseline moving average by a selected percentage; and
activating (412) a notification to check or change an air filter (126) of the HVAC system,
wherein the controller is an electronically commutated motor (ECM) (110) or an equipment control board (108).

7. The controller (105, 108, 110) of claim 6, wherein the operations (400) comprise:
establishing the established baseline moving average and/or establishing the selected percentage.

8. The controller (105, 108, 110) of claim 7, wherein the establishing the established baseline moving average comprises:
operating the blower motor (115) at the desired torque;
monitoring the horsepower (260) of the blower motor over a baseline time period when the blower motor is operating at the desired torque; and
determining the established baseline moving average of the horsepower of the blower motor over the baseline time period.

9. The controller (105, 108, 110) of any of claims 6 to 8, wherein the monitoring the horsepower (260) of the blower motor (115) over the selected time period when the blower motor is operating at the desired torque comprises:
monitoring an electrical current provided to the blower motor over the selected time period when the blower motor is operating at the desired torque;
monitoring an operating speed of the blower motor over the selected time period when the blower motor is operating at the desired torque; and
calculating the horsepower based on the electrical current and the operating speed.

10. The controller (105, 108, 110) of claim any of claims 6 to 9, wherein the activating the notification to check or change the air filter (126) of the HVAC system (100) comprises:
displaying the notification to check or change the air filter of the HVAC system on an interface element (150) of a system control unit (105) of the HVAC system.

11. A computer program product embodied on a non-transitory computer readable medium, the computer program product including instructions that, when executed by a processor, cause the processor to perform operations (400) comprising:
operating (404) a blower motor (115) at a desired torque;
monitoring (406) a horsepower (260) of the blower motor over a selected time period when the blower motor is operating at the desired torque;
determining (408) a moving average of the horsepower of the blower motor over the selected time period;
detecting (410) when the moving average drops below an established baseline moving average by a selected percentage; and
activating (412) a notification to check or change an air filter of a HVAC system.

12. The computer program product of claim 11, wherein the operations (400) comprise:
establishing the established baseline moving average and/or establishing the selected percentage.

13. The computer program product of claim 12, wherein the establishing the established baseline moving average comprises:
operating the blower motor (115) at the desired torque;
monitoring the horsepower (260) of the blower motor over a baseline time period when the blower motor is operating at the desired torque; and
determining the established baseline moving average of the horsepower of the blower motor over the baseline time period.

14. The computer program product of any of claims 11 to 13, wherein the monitoring the horsepower (260) of the blower motor (115) over the selected time period when the blower motor is operating at the desired torque comprises:
monitoring an electrical current provided to the blower motor over the selected time period when the blower motor is operating at the desired torque;
monitoring an operating speed of the blower motor over the selected time period when the blower motor is operating at the desired torque; and
calculating the horsepower based on the electrical current and the operating speed.

15. The computer program product of any of claims 11 to 14, wherein the activating the notification to check or change the air filter (126) of the HVAC system (100) comprises:
displaying the notification to check or change the air filter of the HVAC system on an interface element (150) of a system control unit (105) of the HVAC system.
